(19) **Europäisches Patentamt / European Patent Office / Office européen des brevets**

(11) **EP 1 479 746 B1**

(12) # EUROPÄISCHE PATENTSCHRIFT

(45) Veröffentlichungstag und Bekanntmachung des Hinweises auf die Patenterteilung:
**17.09.2014  Patentblatt 2014/38**

(51) Int Cl.:
***C09J 133/08*** *(2006.01)*

(21) Anmeldenummer: **04010515.7**

(22) Anmeldetag: **04.05.2004**

(54) **Flammfeste und Hitze-aktivierbare Haftklebemassen**

flame resistant heat-activated pressure sensitive adhesive

masse autocollante ignifuge thermoactivable

(84) Benannte Vertragsstaaten:
**DE ES FR GB IT**

(30) Priorität: **21.05.2003   DE 10322898**

(43) Veröffentlichungstag der Anmeldung:
**24.11.2004   Patentblatt 2004/48**

(73) Patentinhaber: **TESA SE**
**20253 Hamburg (DE)**

(72) Erfinder:
• **Husemann, Marc, Dr.**
**22559 Hamburg (DE)**
• **Zöllner, Stephan, Dr.**
**21244 Buchholz / Nordheide (DE)**

(56) Entgegenhaltungen:
**WO-A-95/32257    US-A- 5 851 663**

## Beschreibung

Die Erfindung betrifft Haftklebemassen mit phosphorhaltigen Verbindungen.

Im Zeitalter der Computerisierung werden mehr und mehr elektronische Teile verarbeitet und auch miteinander verklebt. Durch die Minituatisierung werden ebenfalls immer höhere Anforderungen an die Haftklebemassen gestellt. So können z.T. sehr hohe Temperaturen in den elektronischen Schaltkreisen auftreten oder die Haftklebemassen müssen Schwallötbeständig sein. Durch das Schwallötbad werden z.B. auf Schaltkreisen Lötverbindungen hergestellt. Hierbei treten z.T. Temperaturen von größer 280°C, so dass die Gefahr besteht, dass sich die Haftklebemassen unter diesen Temperaturen entzünden.

Daher werden bevorzugt für diese Haftklebemassen Flammschutzmittel eingesetzt. Diese Technik ist bereits seit langem bekannt. So können z.B. Phosphate, Brom- und Chlorhaltige Verbinden, Al-Verbindungen oder Schwefelhaltige Verbindungen eingesetzt werden.

Insbesondere die halogenhaltigen Zusätze werden heute aus Umweltgründen nur noch sehr begrenzt eingesetzt, da bei einem eventuellen Recyclingprozess z.B. Dioxine freigesetzt werden würden.

Die übrigen Zusätze besitzen ebenfalls Nachteile, da sie häufig aufwendig in die Haftklebemasse eingearbeitet werden müssen und z.T. auch bei längerer Anwendung zum migrieren neigen, so dass sich die klebtechnischen Eigenschaften drastisch verändern. Ferner werden z.T. äußerst große Mengen benötigt und eine Flammfestigkeit zu erreichen, die wiederum die klebtechnischen Eigenschaften verschlechtern und das Migrationsproblem vergrößern.

Aufgabe der Erfindung ist es daher, flammfeste und Hitze-aktivierbare Haftklebemassen zur Verfügung zu stellen, die die Nachteile des Stand der Technik nicht aufweisen.

Gelöst wird die Aufgabe überraschend und für den Fachmann in nicht vorhersehbarer Weise durch den Einsatz von Haftklebemassen, die zu mindestens 15 Gew.-% eines phosphorhaltigen kovalent gebunden Monomers enthalten. Die Unteransprüche betreffen bevorzugte Weiterentwicklungen dieser Haftklebemassen.

Erfindungsgemäß basieren die Haftklebemassen auf einem Polymer erhältlich durch radikalische oder anionische Polymerisation einer Monomerenzusammensetzung mit

a) 50 bis 85 Gew.-%, bezogen auf das Gesamtgewicht, aus Acrylsäureestern und/oder Methacrylsäureestern und/oder deren freien Säuren mit der Formel

$$CH_2 = C(R_1)(COOR_2) \qquad (I),$$

wobei $R_1$ = H oder $CH_3$ und $R_2$ eine Alkylkette mit 1 bis 20 C-Atomen oder H ist, und

b) 15 bis 50 Gew.-%, bezogen auf das Gesamtgewicht, aus Vinylverbindungen, copolymerisierbaren Acrylsäureestern oder Methacrylsäureestern mit jeweils mindestens einem Phosphoratom.

In einer Ausführungsform der Erfindung umfasst die Alkylkette $R_2$ in (I) 4 bis 14 C-Atome, bevorzugterweise 4 bis 9 C-Atome.

Neben dem Monomer in a) sind Photoinitiatoren mit einer copolymerisierbaren Doppelbindung als Comonomer enthalten, wobei auch neben dem Comonomer aromatische Vinylverbindungen als weitere Monomere enthalten sein können.

Die Haftklebemassen enthalten Harze und/oder Weichmacher (Plastifizierungsmittel), Füllstoffe, Keimbildner, Blähmittel, Compoundierungsmittel, Alterungsmittel sowie Vernetzer, wobei die Haftklebemassen auch Vernetzer und Promotoren zur Vernetzung oder bei einer Vernetzung mit UV-Licht UV-absobierende Photoinitiatoren enthalten können.

Das erfindungsgemäße Verfahren zur Herstellung von Haftklebemassen besteht darin, dass mit Monomeren mit einer Zusammensetzung von

a) 50 bis 85 Gew.-%, bezogen auf das Gesamtgewicht, aus Acrylsäureestern und/oder Methacrylsäureestern und/oder deren freien Säuren mit der Formel

$$CH_2 = C(R_1)(COOR_2) \qquad (I),$$

wobei $R_1$ = H oder $CH_3$ und $R_2$ eine Alkylkette mit 1 bis 20 C-Atomen oder H ist, und

b) 15 bis 50 Gew.-%, bezogen auf das Gesamtgewicht, aus Vinylverbindungen, copolymerisierbaren Acrylsäureestern oder Methacrylsäureestern mit jeweils mindestens einem Phosphoratom,

eine radikalische oder anionische Polymerisation durchgeführt wird. Für die radikalische Polymerisation werden Initiatorsysteme mit weiteren radikalischen Initiatoren eingesetzt. Als Initiatoren werden für die radikalische Polymerisation thermisch zerfallende radikalbildende Azo- oder Peroxo-Initiatoren eingesetzt. Die Reaktionszeit bei der radikalischen Polymerisation beträgt bevorzugterweise zwischen 2 bis 72 Stunden. Während der radikalischen Polymerisation auf 50° C bis 160° C erwärmt wird.

Das Verfahren zur Herstellung von Haftklebebändern mittels der erfindungsgemäßen Haftklebemasse wird in der Weise durchgeführt, dass

a) das Lösemittel bis zu einem Restanteil von < 1 % aus der Haftklebemasse entfernt wird, anschließend

b) die Haftklebemasse mittels Walzenbeschichtung oder über eine Schmelzdüse oder mittels Extrusionsbeschichtung auf ein Trägermaterial aufgetragen wird, und dann

c) die Haftklebemasse vernetzt wird.

Ferner sieht die Erfindung die Verwendung von erfindungsgemäßen Haftklebemassen für flammfeste und Hitze-aktivierbare Haftklebebänder vor. Die Verwendung von Haftklebebändern und Haftklebemassen erfolgt für die Herstellung bzw. Verklebung von Flexible Printed Circuit Boards.

Haftklebemassen

Die erfindungsgemäßen Haftklebemassen basieren bevorzugt auf Poly(meth)acrylaten.

Die Monomere werden bevorzugt dermaßen gewählt, dass die resultierenden Polymere bei Raumtemperatur oder höheren Temperaturen als Haftklebemassen eingesetzt werden können, insbesondere derart, dass die resultierenden Polymere haftklebende Eigenschaften entsprechend des "Handbook of Pressure Sensitive Adhesive Technology" von Donatas Satas (van Nostrand, New York 1989) besitzen.

Die haftklebrigen Polymere lassen sich bevorzugt durch Polymerisation einer Monomermischung gewinnen, welche sich aus

a) zu 50-85 Gew.-% aus Acrylsäureestern und/oder Methacrylsäureestern und/oder deren freien Säuren mit der Formel

$$CH_2 = CH(R_1)(COOR_2) \qquad (I),$$

wobei $R_1$ = H oder $CH_3$ und $R_2$ eine Alkylkette mit 1 - 20 C-Atomen oder H ist und

b) zu 15 - 50 Gew.-% aus Vinylverbindungen, copolymerisierbaren Acrylsäureestern oder Methacrylsäureestern mit jeweils mindestens einem Phosphoratom

zusammensetzen.

Die Molmassen $M_w$ der eingesetzten Polyacrylate betragen bevorzugt $M_w \geq 200.000$ g/mol.

In einer sehr bevorzugten Weise werden für a) Acryl- oder Methacrylmomonere eingesetzt, die aus Acryl- und Methacrylsäureester mit Alkylgruppen aus 4 bis 14 C-Atomen bestehen, bevorzugt 4 bis 9 C-Atomen umfassen. Spezifische Beispiele, ohne sich durch diese Aufzählung einschränken zu wollen, sind Methlacrylat, Methylmethacrylat, Ethylacrylat, n-Butylacrylat, n-Butylmethacrylat, n-Pentylacrylat, n-Hexylacrylat, n-Heptylacrylat, n-Octylacrylat, n-Octylmethacrylat, n-Nonylacrylat, Laurylacrylat, Stearylacrylat, Behenylacrylat, und deren verzweigten Isomere, wie z.B. Isobutylacrylat, 2-Ethylhexylacrylat, 2-Ethylhexylmethacrylat, Isooctylacrylat, Isooctylmethacrylat.

Weitere einzusetzende Verbindungsklassen sind monofunktionelle Acrylate bzw. Methacrylate von überbrückten Cycloalkylalkoholen, bestehend aus zu mindestens 6 C-Atomen. Die Cycloalkylalkohole können auch substituiert sein, z.B. durch $C_1$-$C_6$-Alkylgruppen, Halogenatomen oder Cyanogruppen. Spezifische Beispiele sind Cyclohexylmethacrylate, Isobomylacrylat, Isobomylmethacrylate und 3,5-Dimethyladamantylacrylat.

In einer Vorgehensweise werden für a) Monomere eingesetzt, die polare Gruppen wie Carboxylreste, Sulfonsäure, Hydroxyreste, Lactam und Lacton, N-substituiertes Amid, N-substituiertes Amin, Carbamat-, Epoxy-, Thiol-, Alkoxy-. Cyanreste, Ether oder ähnliches tragen.

Moderate basische Monomere für a) sind z.B. N,N-Dialkylsubstituierte Amide, wie z.B. N,N-Dimethylacrylamid, N,N-Dimethylmethylmethacrylamid, N-tert.-Butylacrylamid, N-Vinylpyrrolidon, N-Vinyllactam, Dimethylaminoethylmethacrylat, Dimethylaminoethylacrylat, Diethylaminoethylmethacrylat, Diethylaminoethylacrylat, N-Methylolmethacrylamid, N-(Buthoxymethyl)methacrylamid, N-Methylolacrylamid, N-(Ethoxymethyl)acrylamid, N-Isopropylacrylamid, wobei diese Aufzählung nicht abschließend ist.

Weitere bevorzugte Beispiele für a) sind Hydroxyethylacrylat, Hydroxypropylacrylat, Hydroxyethylmethacrylat, Hydroxypropylmethacrylat, Allylalkohol, Maleinsäureanhydrid, Itaconsäureanhydrid, Itaconsäure, Glyceridylmethacrylat, Phenoxyethylacrlylat, Phenoxyethylmethacrylat, 2-Butoxyethylmethacrylat, 2-Butoxyethylacrylat, Cyanoethylmethacrylat, Cyanoethylacrylat, Glycerylmethacrylat, 6-Hydroxyhexylmethacrylat, Vinylessigsäure, Tetrahydrofurfurylacrlyat, β-Acryloyloxypropionsäure, Trichloracrlsäure, Fumarsäure, Crotonsäure, Aconitsäure, Dimethylacrylsäure, wobei diese Aufzählung nicht abschließend ist.

In einer weiteren sehr bevorzugten Vorgehensweise werden als Monomere für a) Vinylester, Vinylether, Vinylhalogenide, Vinylidenhalogenide, Vinylverbindungen mit aromatischen Cyclen und Heterocyclen in α-Stellung eingesetzt. Auch hier seien nicht abschließend einige Beispiele genannt: Vinylacetat, Vinylformamid, Vinylpyridin, Ethylvinylether, Vinylchlorid, Vinylidenchlorid und Acrylonitril.

Die Monomere für b) umfassen alle Phosphorhaltigen copolymerisierbaren Vinylverbindungen, Acryl- und Methacrylsäureester. Spezifische Beispiele sind Vinylphosphonsäure, Vinylphosphonsäurediethylester, Vinylphosphonsäuredimethylester, Phosphorigsäure-monoallylester-bis-(diisopropylamid), Dimethyl-2-acrylooxyethylphosphonat und Diethyl-2-acrylooxyethylphosphonat. In einer besonders bevorzugten Auslegung wird Dimethyl-2-acrylooxyethylphosphonat eingesetzt.

Weiterhin werden optional in einer weiteren Vorgehensweise Photoinitiatoren mit einer copolymerisierbaren Doppelbindung als Comonomer für a) eingesetzt. Als Photoinitiatoren sind Norrish-I- und -II-Photoinitiatoren geeignet. Beispiele sind z.B. Benzoinacrylat und ein acryliertes Benzophenon der Fa. UCB (Ebecryl P 36® ). Im Prinzip können alle dem Fachmann bekannten Photoinitiatoren copolymerisiert werden, die das Polymer über einen Radikalmechnismus unter UV-Bestrahlung vernetzen können. Ein Überblick über mögliche einsetzbare Photoinitiatoren die mit einer Doppelbindung funktionalisiert werden können, wird in Fouassier: "Photoinititation, Photopolymerization and Photocuring: Fundamentals and Applications", Hanser-Verlag, München 1995, gegeben. Ergänzend wird Carroy et al. in "Chemistry and Technology of UV and EB Formulation for Coatings, Inks and Paints", Oldring (Hrsg.), 1994, SITA, London eingesetzt.

In einer weiteren bevorzugten Vorgehensweise werden zu den beschriebenen Comonomeren Monomere hinzugesetzt, die eine hohe statische Glasübergangstemperatur besitzen. Als Komponenten eigenen sich aromatische Vinylverbindungen, wie z.B. Styrol, wobei bevorzugt die aromatischen Kerne aus $C_4$- bis $C_{18}$-Bausteinen bestehen und auch Heteroatome enthalten können. Besonders bevorzugte Beispiele sind 4-Vinylpyridin, N-Vinylphthalimid, Methylstyrol, 3,4-Dimethoxystyrol, 4-Vinylbenzoesäure, Benzylacrylat, Benzylmethacrylat, Phenylacrylat, Phenylmethacrylat, t-Butylphenylacrylat, t-Butylphenylmethacrylat, 4-Biphenylacrylat und- methacrylat, 2-Naphthylacrylat und -methacrylat sowie Mischungen aus denjenigen Monomeren, wobei diese Aufzählung nicht abschließend ist.

Weiterhin ist eine besondere Eigenschaft der erfinderischen Haftklebemasse, dass die Haftklebemassen nicht entflammbar sind. Die Untersuchung der Entflammbarkeit können nach UL-94 VTM-0, ISO 9772 , ISO 9773 und IEC 60707 durchgeführt werden. Im Rahmen dieser Erfindung wurden die erfinderischen Haftklebemassen nach DIN 40633 ausgeprüft, wobei Z 3 = brennbar, Z 2 = selbstverlöschend und Z 1 = nicht brennbar darstellen.

Zur Weiterentwicklung können den erfinderischen Haftklebemassen Harze beigemischt sein. Als zuzusetzende klebrigmachende Harze sind ausnahmslos alle vorbekannten und in der Literatur beschriebenen Klebharze einsetzbar. Genannt seien stellvertretend die Pinen-, Inden- und Kolophoniumharze, deren disproportionierte, hydrierte, polymerisierte, veresterte Derivate und Salze, die aliphatischen und aromatischen Kohlenwasserstoffharze, Terpenharze und Terpenphenolharze sowie $C_5$-, $C_9$- sowie andere Kohlenwasserstoffharze. Beliebige Kombinationen dieser und weiterer Harze können eingesetzt werden, um die Eigenschaften der resultierenden Klebmasse wunschgemäß einzustellen. Im allgemeinen lassen sich alle mit dem entsprechenden Poly(meth)acrylat kompatiblen (löslichen) Harze einsetzen, insbesondere sei verwiesen auf alle aliphatischen, aromatischen, alkylaromatischen Kohlenwasserstoffharze, Kohlenwasserstoffharze auf Basis reiner Monomere, hydrierte Kohlenwasserstoffharze, funktionelle Kohlenwasserstoffharze sowie Naturharze. Auf die Darstellung des Wissensstandes im "Handbook of Pressure Sensitive Adhesive Technology" von Donatas Satas (van Nostrand, 1989) sei ausdrücklich hingewiesen.

Für Hitze-aktivierbare Haftklebemassen kann es von Vorteil sein, Reaktivharze hinzuzusetzen, wie z.B. Phenolharze und Epoxidharze, wie sie z.B. kommerziell erhältlich von der Bakelite AG sind.

Weiterhin können optional Weichmacher (Plastifizierungsmittel), Füllstoffe (wie. z.B. Fasern, Ruß, Zinkoxid, Kreide, Voll- oder Hohlglaskugeln, Mikrokugeln aus anderen Materialien, Kieselsäure, Silikate), Keimbildner, Blähmittel, Compoundierungsmittel und/oder Alterungsschutzmittel, z.B. in Form von primären und sekundären Antioxidantien oder in Form von Lichtschutzmitteln zugesetzt sein.

Zusätzlich können Vernetzer und Promotoren zur Vernetzung beigemischt werden. Geeignete Vernetzer für die Elektronenstrahlvernetzung und UV-Vernetzung sind beispielsweise bi- oder multifunktionelle Acrylate, bi- oder multifunktionelle Isocyanate (auch in blockierter Form) oder bi- oder multifunktionelle Epoxide.

Zu einer optionalen Vernetzung mit UV-Licht können den Polyacrylathaftklebemassen UV-absorbierende Photoinitiatoren zugesetzt werden. Nützliche Photoinitiatoren, welche sehr gut zu verwenden sind, sind Benzoinether, wie z. B. Benzoinmethylether und Benzoinisopropylether, substituierte Acetophenone, wie z. B. 2,2-Diethoxyacetophenon (erhältlich als Irgacure 651® von Fa. Ciba Geigy® ), 2,2-Dimethoxy-2-phenyl-1-phenylethanon, Dimethoxyhydroxyacetophenon, substituierte α-Ketole, wie z. B. 2-Methoxy-2-hydroxypropiophenon, aromatische Sulfonylchloride, wie z. B.

2-Naphthyl sulfonylchlorid, und photoaktive Oxime, wie z. B. 1-Phenyl-1,2-propandion-2-(Oethoxycarbonyl)oxim.

Die oben erwähnten und weitere einsetzbare Photoinititatioren und andere vom Typ Norrish I oder Norrish II können folgenden Reste enthalten: Benzophenon-, Acetophenon-, Benzil-, Benzoin-, Hydroxyalkylphenon-, Phenylcyclohexylketon-, Anthrachinon-, Trimethylbenzoylphosphinoxid-, Methylthiophenylmorpholinketon-, Aminoketon-, Azobenzoin-, Thioxanthon-, Hexarylbisimidazol-, Triazin-, oder Fluorenon, wobei jeder dieser Reste zusätzlich mit einem oder mehreren Halogenatomen und/oder einer oder mehreren Alkyloxygruppen und/oder einer oder mehreren Aminogruppen oder Hydroxygruppen substituiert sein kann. Ein repräsentativer Überblick wird von Fouassier: "Photoinititation, Photopolymerization and Photocuring: Fundamentals and Applications", Hanser-Verlag, München 1995, gegeben. Ergänzend kann Carroy et al. in "Chemistry and Technology of UV and EB Formulation for Coatings, Inks and Paints", Oldring (Hrsg.), 1994, SITA, London herangezogen werden.

Herstellverfahren für die erfinderischen Haftklebemassen

Zur Polymerisation werden die Monomere dermaßen gewählt, dass die resultierenden Polymere bei Raumtemperatur oder höheren Temperaturen als Haftklebemassen oder Hitze-aktivierbare Haftklebemassen eingesetzt werden können, insbesondere derart, dass die resultierenden Polymere haftklebende Eigenschaften entsprechend des "Handbook of Pressure Sensitive Adhesive Technology" von Donatas Satas (van Nostrand, New York 1989) besitzen.

Zur Erzielung einer bevorzugten Glasübergangstemperatur $T_G$ der Polymere von $T_G \leq 25°C$ für Haftklebemassen, die bevorzugt bei Raumtemperatur eingesetzt werden, werden entsprechend dem vorstehend gesagten die Monomere sehr bevorzugt derart ausgesucht und die mengenmäßige Zusammensetzung der Monomermischung vorteilhaft derart gewählt, daß sich nach der Fox-Gleichung (G1) (vgl. T.G. Fox, Bull. Am. Phys. Soc. 1 (1956) 123) der gewünschte $T_G$-Wert für das Polymer ergibt.

$$\frac{1}{T_G} = \sum_n \frac{w_n}{T_{G,n}} \qquad (G1)$$

Hierin repräsentiert n die Laufzahl über die eingesetzten Monomere, $w_n$ den Massenanteil des jeweiligen Monomers n (Gew.-%) und $T_{G,n}$ die jeweilige Glasübergangstemperatur des Homopolymers aus den jeweiligen Monomeren n in K.

Für Hitzeaktivierbare Haftklebemassen beträgt die Glasübergangstemperatur bevorzugt größer 25°C, sehr bevorzugt größer 40°C. Es wird wiederum analog zur Fox-Gleichung (G1) vorgegangen.

Zur Herstellung der Poly(meth)acrylathaftklebemassen werden vorteilhaft konventionelle radikalische Polymerisationen mit den Monomeren 1) und 2) bzw. den zusätzlichen Monomeren durchgeführt. Für die radikalisch verlaufenden Polymerisationen werden bevorzugt Initiatorsysteme eingesetzt, die zusätzlich weitere radikalische Initiatoren zur Polymerisation enthalten, insbesondere thermisch zerfallende radikalbildende Azo- oder Peroxo-Initiatoren. Prinzipiell eignen sich jedoch alle für Acrylate dem Fachmann geläufigen, üblichen Initiatoren. Die Produktion von C-zentrierten Radikalen ist im Houben Weyl, Methoden der Organischen Chemie, Vol. E 19a, S. 60 - 147 beschrieben. Diese Methoden werden in bevorzugter Weise in Analogie angewendet.

Beispiele für Radikalquellen sind Peroxide, Hydroperoxide und Azoverbindungen, als einige nicht ausschließliche Beispiele für typische Radikalinitiatoren seien hier genannt Kaliumperoxodisulfat, Dibenzoylperoxid, Cumolhydroperoxid, Cyclohexanonperoxid, Di-t-butylperoxid, Azodüsosäurebutyronitril, Cyclohexylsulfonylacetylperoxid, Diisopropylpercarbonat, t-Butylperoktoat, Benzpinacol. In einer sehr bevorzugten Auslegung wird als radikalischer Initiator 1,1'-Azo-bis-(cyclohexancarbonsäurenitril) (Vazo 88™ der Fa. DuPont) oder Azodisobutyronitril (AIBN) verwendet.

Die mittleren Molekulargewichte $M_w$ der bei der radikalischen Polymerisation entstehenden Haftklebemassen werden sehr bevorzugt derart gewählt, dass sie in einem Bereich von 200.000 bis 4.000.000 g/mol liegen; speziell für die weitere Verwendung als Haftkleber mit anisotropem Verhalten werden Haftklebemassen mit mittleren Molekulargewichten $M_w$ von 400.000 bis 1.400.000 g/mol hergestellt. Die Bestimmung des mittleren Molekulargewichtes erfolgt über Größenausschlußchromatographie (GPC) oder Matrix-unterstützte Laser-Desorption/Ionisations-Massenspektrometrie (MALDI-MS).

Die Polymerisation kann in Substanz, in Gegenwart eines oder mehrerer organischer Lösungsmittel, in Gegenwart von Wasser oder in Gemischen aus organischen Lösungsmitteln und Wasser durchgeführt werden. Es wird dabei angestrebt, die verwendete Lösungsmittelmenge so gering wie möglich zu halten. Geeignete organische Lösungsmittel sind reine Alkane (z.B. Hexan, Heptan, Octan, Isooctan), aromatische Kohlenwasserstoffe (z.B. Benzol, Toluol, Xylol), Ester (z.B. Essigsäureethylester, Essigsäurepropyl-, -butyl- oder -hexylester), halogenierte Kohlenwasserstoffe (z.B. Chlorbenzol), Alkanole (z.B. Methanol, Ethanol, Ethylenglycol, Ethylenglycolmonomethylether) und Ether (z.B. Diethylether, Dibutylether) oder Gemische davon. Die wäßrigen Polymerisationsreaktionen können mit einem mit Wasser mischbaren oder hydrophilen Colösungsmittel versetzt werden, um zu gewährleisten, daß das Reaktionsgemisch während des Monomerumsatzes in Form einer homogenen Phase vorliegt. Vorteilhaft verwendbare Colösungsmittel für die vorliegende Erfindung werden gewählt aus der folgenden Gruppe, bestehend aus aliphatischen Alkoholen, Glycolen, Ethern, Glycolethern, Pyrrolidinen, N-Alkylpyrrolidinonen, N-Alkylpyrrolidonen, Polyethylenglycolen, Polypropylenglycolen, Amiden, Carbonsäuren und Salzen davon, Estern, Organosulfiden, Sulfoxiden, Sulfonen, Alkoholderivaten, Hydroxyetherderivaten, Aminoalkoholen, Ketonen und dergleichen, sowie Derivaten und Gemischen davon.

Die Polymerisationszeit beträgt - je nach Umsatz und Temperatur - zwischen 2 und 72 Stunden. Je höher die Reaktionstemperatur gewählt werden kann, das heißt, je höher die thermische Stabilität des Reaktionsgemisches ist, desto geringer kann die Reaktionsdauer gewählt werden.

Zur Initiierung der Polymerisation ist für die thermisch zerfallenden Initiatoren der Eintrag von Wärme essentiell. Die Polymerisation kann für die thermisch zerfallenden Initiatoren durch Erwärmen auf 50 bis 160 °C, je nach Initiatortyp, initiiert werden.

Für die Herstellung kann es auch von Vorteil sein, die Acrylathaftklebemassen in Substanz zu polymerisieren. Hier eignet sich insbesondere die Präpolymerisationstechnik einzusetzen. Die Polymerisation wird mit UV-Licht initiiert, aber nur zu einem geringen Umsatz ca. 10 - 30 % geführt. Anschließend kann dieser Polymersirup z.B. in Folien eingeschweißt werden (im einfachsten Fall Eiswürfel) und dann in Wasser zu hohem Umsatz durchpolymerisiert werden. Diese Pellets lassen sich dann als Acrylatschmelzkleber einsetzen, wobei für den Aufschmelzvorgang besonders bevorzugt Folienmaterialien eingesetzt werden, die mit dem Polyacrylat kompatibel sind. Auch für diese Präparationsmethode lassen sich die thermisch-leitfähigen Materialzusätze vor oder nach der Polymerisation zusetzen.

In weiteren Auslegungsvarianten der Erfindung werden zur Herstellung der erfinderischen Haftklebemassen kontrollierte radikalische oder lebende Polymerisationsprozesse eingesetzt.

Ein anderes vorteilhaftes Herstellungsverfahren für die Poly(meth)acrylathaftklebemassen ist die anionische Polymerisation. Hier werden als Reaktionsmedium bevorzugt inerte Lösungsmittel verwendet, wie z.B. aliphatische und cycloaliphatische Kohlenwasserstoffe, oder auch aromatische Kohlenwasserstoffe.

Beschichtung, Träger, Vernetzung

Zur Herstellung von Haftklebebändern werden die oben beschriebenen Polymere aus Lösung oder bevorzugt als Hotmelt-Systeme (also aus der Schmelze) beschichtet. Für das Herstellungsverfahren kann es daher erforderlich sein, das Lösemittel von der Haftklebemasse zu entfernen. Hier können im Prinzip alle dem Fachmann bekannten Verfahren eingesetzt werden. Ein sehr bevorzugtes Verfahren ist die Aufkonzentration über einen Ein- oder Doppelschneckenextruder. Der Doppelschneckenextruder kann gleich- oder gegenläufig betrieben werden. Das Lösemittel oder Wasser wird bevorzugt über mehrere Vakuumstufen abdestilliert. Zudem wird je nach Destillationstemperatur des Lösemittels gegengeheizt. Die Restlösemittelanteile betragen bevorzugt < 1 %, mehr bevorzugt < 0,5 % und sehr bevorzugt < 0,2 %. Der Hotmelt wird aus der Schmelze weiterverarbeitet.

Insbesondere für die Verarbeitung aus der Schmelze weisen die erfinderischen Haftklebemassen Vorteile auf, da auf einen weiteren Prozessschritt der Additivierung mit Flammschutzmitteln verzichtet werden kann.

In einer weiteren bevorzugten Ausführungsform wird eine Orientierung innerhalb der Haftklebemasse durch das Beschichtungsverfahren erzeugt. Zur Beschichtung als Hotmelt und können unterschiedliche Beschichtungsverfahren herangezogen werden. In einer Ausführung werden die erfinderischen Haftklebemassen über ein Walzenbeschichtungsverfahren beschichtet. Eine Orientierung kann - wenn erforderlich - über Recken erzeugt werden. Unterschiedliche Walzenbeschichtungsverfahren sind im "Handbook of Pressure Sensitive Adhesive Technology" von Donatas Satas (van Nostrand, New York 1989) beschrieben. In einer weiteren Ausführung werden die erfinderischen Haftklebemassen über eine Schmelzdüse beschichtet. Hier kann zwischen dem Kontakt und dem Kontaktlosen Verfahren unterschieden werden.

In einem weiteren Verfahren wird die erfinderische Haftklebemasse durch die Extrusionsbeschichtung aufgetragen. Die Extrusionsbeschichtung wird bevorzugt mit einer Extrusionsdüse vorgenommen. Die verwendeten Extrusionsdüsen können vorteilhaft aus einer der drei folgenden Kategorien stammen: T-Düse, Fischschwanz-Düse und Bügel-Düse. Die einzelnen Typen unterscheiden sich durch die Gestalt ihres Fließkanals. Durch die Form der Extrusionsdüse kann ebenfalls eine Orientierung innerhalb des Schmelzhaftklebers erzeugt werden. Weiterhin kann hier - in Analogie zur Schmelzdüsenbeschichtung - ebenfalls eine Orientierung nach dem Düsenaustritt durch Reckung des Haftklebebandfilmes erzielt werden.

Die mit der erfinderischen Haftklebemasse ausgerüsteten Haftklebebänder können unterschiedliche Formen annehmen.

In einer Ausführung werden Transfer-Tapes hergestellt. Als Trägermaterial eignen sich z.B. alle silikonisierten oder fluorierten Folien mit einer Releasewirkung. Als Folienmaterialien seien hier nur beispielhaft BOPP, MOPP, PET, PVC , PUR, PE, PE/EVA, EPDM, PP und PE genannt. Weiterhin lassen sich für Transfertapes auch Trennpapiere (Glassine Papiere, Kraft Papiere, polyolefinisch beschichtete Papiere) einsetzen.

Für den Fall, dass das Trägermaterial in der Haftklebemasse verbleibt (z.B. in Form einer Trägerfolie), wird bevorzugt ein Trägermaterial eingesetzt, welches ebenfalls eine hohe Flammfestigkeit besitzt. Auch für diesen Fall lassen sich Folien einsetzen, die z.B. entsprechende Flammschutzmittel wie Phosphor enthalten. Es können aber auch Metallfolien eingesetzt werden. Folien können z.B. auf Polyimiden, PET oder PEN basieren.

Zur optionalen UV-Vernetzung wird mittels kurzwelliger ultravioletter Bestrahlung in einem Wellenlängenbereich von 200 bis 400 nm, je nach verwendetem UV-Photoinitiator, bestrahlt, insbesondere unter Verwendung von Quecksilber-Hochdruck- oder - Mitteldruck-Lampen bei einer Leistung von 80 bis 240 W/cm. Die Bestrahlungsintensität wird der jeweiligen Quantenausbeute des UV-Photoinitiators und dem einzustellenden Vernetzungsgrad angepasst.

Weiterhin ist es möglich, die erfinderischen Haftklebemassen mit Elektronenstrahlen zu vernetzen. Typische Bestrahlungsvorrichtungen, die zum Einsatz kommen können, sind Linearkathodensysteme, Scannersysteme bzw. Segmentkathodensysteme, sofern es sich um Elektronenstrahlbeschleuniger handelt. Eine ausführliche Beschreibung des Stands der Technik und die wichtigsten Verfahrensparameter findet man bei Skelhorne, Electron Beam Processing, in Chemistry and Technology of UV and EB formulation for Coatings, Inks and Paints, Vol. 1, 1991, SITA, London. Die typischen Beschleunigungsspannungen liegen im Bereich zwischen 50 kV und 500 kV, vorzugsweise 80 kV und 300 kV. Die angewandten Streudosen bewegen sich zwischen 5 bis 150 kGy, insbesondere zwischen 20 und 100 kGy.

Es können auch beide Vernetzungsverfahren angewendet werden oder andere Verfahren, die hochenergetische Bestrahlung ermöglichen.

In einer weiteren Ausführungsform werden die erfinderischen Haftklebemassen thermisch vernetzt. Hierzu können die erfinderischen Haftklebemassen Multifunktionelle Epoxide, Isocyanate, Hydroxide, Amine, Metallsalze oder Metallchelate enthalten, die dann unter Temperaturaktivierung mit der Polymerkette der erfinderischen Haftklebemasse reagieren.

Die Messung der Orientierung der erfinderischen Haftklebemasse kann mit einem Polarimeter, mit Infrarot-Dichroismus oder mit Röntgenstreuung erfolgen. Es ist bekannt, daß die Orientierung in Acrylathaftklebemassen im unvernetzten Zustand in vielen Fällen lediglich einige Tage erhalten bleibt. Das System relaxiert in der Ruhe- oder Lagerungszeit und verliert seine Vorzugsrichtung. Durch die Vernetzung nach der Beschichtung kann dieser Effekt bedeutend verstärkt werden. Die Relaxierung der orientierten Polymerketten konvergiert gegen Null, und die orientierten Haftklebemassen können ohne Verlust ihrer Vorzugsrichtung über einen sehr großen Zeitraum gelagert werden.

In einer bevorzugten Methode wird das Maß der Orientierung durch die Messung des Rückschrumpfes im freien Film ermittelt.

Verwendung

Weiterhin betrifft die Erfindung die Verwendung der flammfesten erfinderischen Haftklebemassen für Haftklebebänder. Derartige Produkte werden besonders bevorzugt zur Verklebung in der Elektrik- und Elektronikindustrie eingesetzt. Besonders bevorzugt werden solche erfinderischen Haftklebebänder zur Verklebung von flexiblen Leiterbahnen eingesetzt, die z.B. mit Epoxidplatten z.T. verstärkt werden. Diese Verbindung muss Lötbadbeständig sein und dementsprechend auch flammfest. Weiterhin wird die erfinderische Haftklebemasse zur Herstellung von Flexible Printed Circuit Boards eingesetzt, wobei hier Cu-Folien und Polyimid bzw. Polyesterfolien miteinander verklebt werden.

Experimente

Die Erfindung wird im folgenden durch Experimente beschrieben, ohne sich durch die Wahl der untersuchten Proben unnötig beschränken zu wollen.

Folgende Testmethoden wurden angewendet.

180° Klebkrafttest (Test A)

Ein 20 mm breiter Streifen einer auf einer Polyester gecoateten Haftklebemasse wurde auf Stahlplatten aufgebracht. Es wurde - je nach Richtung und Reckung - Längs oder Quermuster auf der Stahlplatte verklebt. Der Haftklebestreifen wurde zweimal mit einem 2 kg Gewicht auf das Substrat aufgedrückt. Das Klebeband wurde anschließend sofort mit 30 mm/min und im 180° Winkel vom Substrat abgezogen. Die Stahlplatten wurden zweimal mit Aceton und einmal mit Isopropanol gewaschen. Die Messergebnisse sind in N/cm angegeben und sind gemittelt aus drei Messungen. Alle Messungen wurden bei Raumtemperatur unter klimatisierten Bedingungen durchgeführt.

Flammfestigkeit (Test B)

Der Test wurde analog DIN 40633 durchgeführt. Die Muster wurden für diesen Test vom Trennpapier auf eine Polyimidfolie (Kapton™ der Fa. DuPont) umkaschiert.

Verklebungsfestigkeit (Test C)

Ein 10 mm breiter Streifen einer auf einer Polyimid-Folie gecoateten Hitze-aktivierbaren Haftklebemasse wurde auf eine Stahlplatte mit 200°C und einem Anpreßdruck von 2 bar auflaminiert. Die Druck/Temperaturbelastung wurde für 10 Sekunden vorgenommen. Das Klebeband wurde anschließend sofort mit 30 mm/min und im 180° Winkel vom Substrat abgezogen. Die Stahlplatten wurden zweimal mit Aceton und einmal mit Isopropanol gewaschen. Die Messergebnisse sind in N/cm angegeben und sind gemittelt aus drei Messungen. Alle Messungen wurden bei Raumtemperatur unter klimatisierten Bedingungen durchgeführt.

Herstellung der Proben

Referenzbeispiel 1

Ein für radikalische Polymerisationen konventioneller 2 I-Glasreaktor wurde mit 8 g Acrylsäure, 392 g 2-Ethylhexylacrylat, und 300 g Aceton/Isopropanol (97:3) befüllt. Nach 45 Minuten Durchleiten mit Stickstoffgas unter Rühren wurde der Reaktor auf 58°C hochgeheizt und 0.2 g Vazo 67® (Fa. Du Pont) hinzugegeben. Anschließend wurde das äußere Heizbad auf 75°C erwärmt und die Reaktion konstant bei dieser Außentemperatur durchgeführt. Nach 1 h Reaktionszeit wurde wiederum 0.2 g Vazo 67® hinzugegeben. Nach 3 und 6 h wurde mit jeweils 150 g Aceton/Isopropanol Gemisch verdünnt. Zur Reduktion der Restinitiatoren wurden nach 8 und nach 10 h jeweils 0.4 g Perkadox 16® (Fa. Akzo Nobel) hinzugegeben. Die Reaktion wurde nach 22 h Reaktionszeit abgebrochen und auf Raumtemperatur abgekühlt. Die Klebemasse wurden dann unter Wärme und im Vakuum vom Lösungsmittel befreit und als Hotmelt durch eine Düse auf eine silikonisiertes Trennpapier (der Fa. Laufenberg) beschichtet (Masseauftrag 50 g/m$^2$).
Die Haftklebemassen wurde mit 60 kGy und 200 kV ES vernetzt und nach den Testmethoden A und B ausgetestet.

Referenzbeispiel 2

Es wurde analog Referenzbeispiel 1 vorgegangen. Das Polymer wurde mit 30 Gew.-% Magnesiumhydroxid/Aluminiumhydroxid (Martinal OL-104S) abgemischt.

Referenzbeispiel 3

Es wurde analog Referenzbeispiel 1 vorgegangen. Das Polymer wurde mit 45 Gew.-% Magnesiumhydroxid/Aluminiumhydroxid (Martinal OL-104S) abgemischt.

Referenzbeispiel 4

Es wurde analog Referenzbeispiel 1 vorgegangen. Das Polymer wurde mit 15 Gew.-% mikroverkapselten roter Phosphor (Safest S3) abgemischt.

Referenzbeispiel 5

Es wurde analog Referenzbeispiel 1 vorgegangen. Das Polymer wurde mit 60 Gew.-% Oligophosphat (Reofos 65™ der Fa. Great Lake Chemicals) abgemischt.

Referenzbeispiel 6

Es wurde analog Referenzbeispiel 1 vorgegangen. Das Polymer wurde mit 20 Gew.-% Ammoniumpolyphosphat (Pyrovatex) abgemischt.

Beispiel 1

Ein für radikalische Polymerisationen konventioneller 2 I-Glasreaktor wurde mit 8 g Acrylsäure, 60 g Dimethyl-2-acryloxyethylphosphonat, 332 g 2-Ethylhexylacrylat, und 300 g Aceton/Isopropanol (97:3) befüllt. Nach 45 Minuten Durchleiten mit Stickstoffgas unter Rühren wurde der Reaktor auf 58°C hochgeheizt und 0.2 g Vazo 67® (Fa. Du Pont) hinzugegeben. Anschließend wurde das äußere Heizbad auf 75°C erwärmt und die Reaktion konstant bei dieser Außentemperatur durchgeführt. Nach 1 h Reaktionszeit wurde wiederum 0.2 g Vazo™ 67 (DuPont, 2,2-Azobis-(I-methylbutyronitril) hinzugegeben. Nach 3 und 6 h wurde mit jeweils 150 g Aceton/Isopropanol Gemisch verdünnt. Zur Reduktion der Restinitiatoren wurden nach 8 und nach 10 h jeweils 0.4 g Perkadox™ 16 (Fa. Akzo Nobel Di-(4-tert.-butylcyclohexyl)peroxy dicarbonat) hinzugegeben. Die Reaktion wurde nach 22 h Reaktionszeit abgebrochen und auf Raumtemperatur abgekühlt. Die Klebemasse wurden dann unter Wärme und im Vakuum vom Lösungsmittel befreit und als Hotmelt durch eine Düse auf eine silikonisiertes Trennpapier (der Fa. Laufenberg) beschichtet (Masseauftrag 50 g/m$^2$).
Die Haftklebemassen wurde mit 60 kGy und 200 kV ES vernetzt und nach den Testmethoden A und B ausgetestet.

Beispiel 2

Ein für radikalische Polymerisationen konventioneller 2 l-Glasreaktor wurde mit 20 g Acrylsäure, 90 g Dimethyl-2-acryloxyethylphosphonat, 302 g 2-Ethylhexylacrylat, und 300 g Aceton/Isopropanol (97:3) befüllt. Nach 45 Minuten Durchleiten mit Stickstoffgas unter Rühren wurde der Reaktor auf 58°C hochgeheizt und 0.2 g Vazo™ 67 (Fa. Du Pont) hinzugegeben. Anschließend wurde das äußere Heizbad auf 75°C erwärmt und die Reaktion konstant bei dieser Außentemperatur durchgeführt. Nach 1 h Reaktionszeit wurde wiederum 0.2 g Vazo™ 67 hinzugegeben. Nach 3 und 6 h wurde mit jeweils 150 g Aceton/Isopropanol Gemisch verdünnt. Zur Reduktion der Restinitiatoren wurden nach 8 und nach 10 h jeweils 0.4 g Perkadox™ 16 (Fa. Akzo Nobel) hinzugegeben. Die Reaktion wurde nach 22 h Reaktionszeit abgebrochen und auf Raumtemperatur abgekühlt. Die Klebemasse wurden dann unter Wärme und im Vakuum vom Lösungsmittel befreit und als Hotmelt durch eine Düse auf eine silikonisiertes Trennpapier (der Fa. Laufenberg) beschichtet (Masseauftrag 50 g/m$^2$).
Die Haftklebemassen wurde mit 60 kGy und 200 kV ES vernetzt und nach den Testmethoden A und B ausgetestet.

Beispiel 3

Ein für radikalische Polymerisationen konventioneller 2 l-Glasreaktor wurde mit 20 g Acrylsäure, 120 g Dimethyl-2-acryloxyethylphosphonat, 100 g Methylmethacrylat, 160 g 2-Ethylhexylacrylat, und 300 g Aceton/Isopropanol (95:5) befüllt. Nach 45 Minuten Durchleiten mit Stickstoffgas unter Rühren wurde der Reaktor auf 58°C hochgeheizt und 0.2 g Vazo™ 67 (Fa. Du Pont) hinzugegeben. Anschließend wurde das äußere Heizbad auf 75°C erwärmt und die Reaktion konstant bei dieser Außentemperatur durchgeführt. Nach 1 h Reaktionszeit wurde wiederum 0.2 g Vazo™ 67 hinzugegeben. Nach 3 und 6 h wurde mit jeweils 150 g Aceton/Isopropanol Gemisch verdünnt. Zur Reduktion der Restinitiatoren wurden nach 8 und nach 10 h jeweils 0.4 g Perkadox™ 16 (Fa. Akzo Nobel) hinzugegeben. Die Reaktion wurde nach 22 h Reaktionszeit abgebrochen und auf Raumtemperatur abgekühlt. Die Klebemasse wurden dann unter Wärme und im Vakuum vom Lösungsmittel befreit und als Hotmelt durch eine Düse auf eine silikonisiertes Trennpapier (der Fa. Laufenberg) beschichtet (Masseauftrag 50 g/m$^2$).
Die Haftklebemassen wurde mit 60 kGy und 200 kV ES vernetzt und nach den Testmethoden B und C ausgetestet.

Resultate

In einem ersten Schritt wurde die Flammfestigkeit von allen Beispielen ermittelt. Die Kategorisierung fand nach Z = 1 (nicht brennbar) , Z = 2 (selbstverlöschend) und Z = 3 (brennbar) nach DIN 40633 statt.

Tabelle 1. Übersicht Flammfestigkeit (Test B).

| Beispiele | Flammfestigkeit (Test B) |
|---|---|
| Referenzbeispiel1 | Z = 3 |
| Referenzbeispiel2 | Z = 3 |
| Referenzbeispiel3 | Z = 2 |
| Referenzbeispiel4 | Z = 2 |
| Referenzbeispiel5 | Z = 3 |
| Referenzbeispiel6 | Z = 2 |
| 1 | Z = 1 |
| 2 | Z = 1 |
| 3 | Z = 1 |

Der Tabelle 1 ist zu entnehmen, dass nur mit den erfinderischen Beispielen 1 bis 3 die höchste Stufe Z = 1 erreicht wurde und somit diese Haftklebemassen absolut nicht brennbar sind.
Zur weiteren Charakterisierung wurden von den haftklebrigen Beispielen die Klebkraft auf Stahl bestimmt.

Die ermittelten Werte sind in Tabelle 2 zusammengefasst.

Tabelle 2: Klebkraft auf Stahl

| Beispiel | Klebkraft auf Stahl (Test A) in [N/cm] |
|---|---|
| Referenzbeispiel1 | 4.5 |
| Referenzbeispiel2 | 1.0 |
| Referenzbeispiel3 | 0.5 |
| Referenzbeispiel4 | 3.4 |
| Referenzbeispiel5 | 1.0 |
| Referenzbeispiel6 | 3.4 |
| Beispiel1 | 4.5 |
| Beispiel2 | 4.9 |

Alle Referenzbeispiele zeigen durch die Additivierung eine reduzierte Sofortklebkraft auf Stahl. Die erfinderischen Beispiele zeigen dagegen eine unveränderte Klebkraft und weisen somit deutliche Vorteile gegenüber bestehende Konzepte zur Verbesserung des Flammschutzes von Acrylathaftklebemassen.

Für das Hitzeaktivierbare Beispiel 3 wurde die Klebkraft auf Stahl nach Hitzeaktivierung bei 200°C gemessen. Für Beispiel 3 ergab sich eine Verklebungsfestigkeit von 43 N/cm.

**Patentansprüche**

1. Haftklebemasse basierend auf einem Polymer erhältlich durch Polymerisation einer Monomerenzusammensetzung mit

   a) 50 bis 85 Gew.-%, bezogen auf das Gesamtgewicht, aus Acrylsäureestern und/oder Methacrylsäureestern und/oder deren freien Säuren mit der Formel

   $$CH_2 = C(R_1)(COOR_2) \qquad (I),$$

   wobei $R_1$ = H oder $CH_3$ und $R_2$ eine Alkylkette mit 1 bis 20 C-Atomen oder H ist, und
   b) 15 bis 50 Gew.-%, bezogen auf das Gesamtgewicht, aus Vinylverbindungen, copolymerisierbaren Acrylsäureestern oder Methacrylsäureestern mit jeweils mindestens einem Phosphoratom.

2. Haftklebemasse nach Anspruch 1, **dadurch gekennzeichnet, dass** sie nach DIN 40633 flammfest ist.

3. Haftklebemasse nach einem oder mehreren der Ansprüche 1 oder 2, **dadurch gekennzeichnet, dass** neben dem Monomer in a) Photoinitiatoren mit einer copolymerisierbaren Doppelbindung als Comonomer enthalten sind.

4. Haftklebemasse nach Anspruch 3, **dadurch gekennzeichnet, dass** neben dem Comonomer aromatische Vinylverbindungen als weitere Monomere enthalten sind.

5. Haftktebemasse nach einem oder mehreren der Ansprüche 1 bis 4, **dadurch gekennzeichnet, dass** die Haftklebemassen Vernetzer und Promotoren zur Vernetzung oder UV-absorbierende Photoinitiatoren enthalten.

6. Verfahren zur Herstellung von Haftklebemassen,
   **dadurch gekennzeichnet, dass**
   mit Monomeren mit einer Zusammensetzung von

   a) 50 bis 85 Gew.-%, bezogen auf das Gesamtgewicht, aus Acrylsäureestern und/oder Methacrylsäureestern und/oder deren freien Säuren mit der Formel

   $$CH_2 = C(R_1)(COOR_2) \qquad (I),$$

wobei $R_1$ = H oder $CH_3$ und $R_2$ eine Alkylkette mit 1 bis 20 C-Atomen oder H ist, und

b) 15 bis 50 Gew.-%, bezogen auf das Gesamtgewicht, aus Vinylverbindungen, copolymerisierbaren Acrylsäureestern oder Methacrylsäureestern mit jeweils mindestens einem Phosphoratom,

eine radikalische oder anionische Polymerisation durchgeführt wird.

7. Verfahren zur Herstellung von Haftklebebändern mit einer Haftklebemässe nach Anspruch 1, **dadurch gekennzeichnet, dass** die in Anspruch 6 erhältlichen Polymere aus der Schmelze beschichtet werden, insbesondere mit einem Restlösemittelanteil von weniger als 1 %.

8. Verfahren nach Anspruch 7, **dadurch gekennzeichnet**, das durch die Beschichtung aus der Schmelze eine Orientierung in der flammfesten Haftklebemasse erzeugt wird.

9. Verfahren zur Herstellung von Haftklebebändern nach einem oder mehreren der Ansprüche 7 oder 8, **dadurch gekennzeichnet, dass** als Trägermaterial silikonisierte oder fluorierte Folien, Trennpapiere oder Flammschutzmittel enthaltende Folien eingesetzt werden.

10. Verfahren zur Herstellung von Haftklebebändern nach einem oder mehreren der Ansprüche 6 bis 9, **dadurch gekennzeichnet, dass** eine Vernetzung der Haftklebemasse mittels hochenergetischer Bestrahlung oder thermisch durchgeführt wird.

11. Haftklebeband, erhältlich nach einem oder mehreren der Ansprüche 7 bis 10, **dadurch gekennzeichnet, dass** auch das Trägermaterial nach DIN 40633 flammfest ist.

12. Verwendung von Acrylathaftklebemassen nach Anspruch 1 für nach DIN 40633 flammfeste und Hitze-aktivierbare Haftklebebänder.

13. Verwendung von Haftklebebändern oder Haftklebemassen nach einem oder mehreren der Ansprüche 1 bis 6 oder 11 für die Herstellung bzw. Verklebung von Flexible Printed Circuit Boards.

**Claims**

1. Pressure-sensitive adhesive (PSA) based on a polymer obtainable by polymerizing a monomer composition with

   a) 50 to 85 wt%, based on the total weight, of acrylic esters and/or methacrylic esters and/or the corresponding free acids, with the formula

   $$CH_2 = C(R_1)(COOR_2) \qquad (I),$$

   where $R_1$ = H or $CH_3$ and $R_2$ is an alkyl chain having 1 to 20 C atoms or H, and
   b) 15 to 50 wt%, based on the total weight, of vinyl compounds, copolymerizable acrylic esters or methacrylic esters having in each case at least one phosphorus atom.

2. Pressure-sensitive adhesive according to Claim 1, **characterized in that** it is flame retardant to DIN 40633.

3. Pressure-sensitive adhesive according to one or both of Claims 1 and 2, **characterized in that** in addition to the monomer in a) there are photoinitiators having a copolymerizable double bond present as comonomer.

4. Pressure-sensitive adhesive according to Claim 3, **characterized in that** in addition to the comonomer there are aromatic vinyl compounds present as further monomers.

5. Pressure-sensitive adhesive according to one or more of Claims 1 to 4, **characterized in that** the pressure-sensitive adhesive comprises crosslinkers and promoters for crosslinking, or UV-absorbing photoinitiators.

**6.** Process for preparing pressure-sensitive adhesives, **characterized in that** a radical or anionic polymerization is carried out with monomers with a composition of

a) 50 to 85 wt%, based on the total weight, of acrylic esters and/or methacrylic esters and/or the corresponding free acids, with the formula

$$CH_2 = C(R_1)(COOR_2) \qquad (I),$$

where $R_1$ = H or $CH_3$ and $R_2$ is an alkyl chain having 1 to 20 C atoms or H, and
b) 15 to 50 wt%, based on the total weight, of vinyl compounds, copolymerizable acrylic esters or methacrylic esters having in each case at least one phosphorus atom.

**7.** Process for producing pressure-sensitive adhesive tapes with a pressure-sensitive adhesive according to Claim 1, **characterized in that** the polymers obtainable in Claim 6 are coated from the melt, more particularly with a residual solvent fraction of less than 1%.

**8.** Process according to Claim 7, **characterized in that** the coating from the melt generates an orientation in the flame retardant pressure-sensitive adhesive.

**9.** Process for producing pressure-sensitive adhesive tapes according to one or both of Claims 7 and 8, **characterized in that** carrier materials used are siliconized or fluorinated films, release papers, or films comprising flame retardant.

**10.** Process for producing pressure-sensitive adhesive tapes according to one or more of Claims 6 to 9, **characterized in that** the pressure-sensitive adhesive is crosslinked by means of high-energy irradiation or thermally.

**11.** Pressure-sensitive adhesive tape obtainable according to one or more of Claims 7 to 10, **characterized in that** the carrier material is also flame retardant to DIN 40633.

**12.** Use of acrylate PSAs according to Claim 1 for heat-activatable pressure-sensitive adhesive tapes which are flame retardant to DIN 40633.

**13.** Use of pressure-sensitive adhesive tapes or PSAs according to one or more of Claims 1 to 6 or 11 for producing and/or adhesively bonding flexible printed circuit boards.

**Revendications**

**1.** Masse autoadhésive à base d'un polymère pouvant être obtenu par polymérisation d'une composition de monomères présentant

a) 50 à 85% en poids, par rapport au poids total, d'esters de l'acide acrylique et/ou d'esters de l'acide méthacrylique et/ou de leurs acides libres de formule

$$CH_2 = C(R_1)(COOR_2) \qquad (I),$$

où $R_1$ = H ou $CH_3$ et $R_2$ représente une chaîne alkyle comprenant 1 à 20 atomes de carbone ou H, et
b) 15 à 50% en poids, par rapport au poids total, de composés de vinyle, d'esters de l'acide acrylique ou d'esters de l'acide méthacrylique, copolymérisables, présentant à chaque fois au moins un atome de phosphore.

**2.** Masse autoadhésive selon la revendication 1, **caractérisée en ce qu'**elle est résistante à la flamme selon la norme DIN 40633.

**3.** Masse autoadhésive selon l'une ou plusieurs des revendications 1 ou 2, **caractérisée en ce qu'**elle contient dans a), outre le monomère, des photo-initiateurs présentant une double liaison copolymérisable comme comonomère.

**4.** Masse autoadhésive selon la revendication 3, **caractérisée en ce qu'**elle contient, outre le comonomère, des composés aromatiques de vinyle comme autres monomères.

**5.** Masse autoadhésive selon l'une ou plusieurs des revendications 1 à 4, **caractérisée en ce que** la masse autoadhésive contient des réticulants et des promoteurs pour la réticulation ou des photo-initiateurs absorbant les UV.

**6.** Procédé pour la préparation de masses autoadhésives, **caractérisé en ce qu'**on réalise, à l'aide de monomères présentant une composition de

a) 50 à 85% en poids, par rapport au poids total, d'esters de l'acide acrylique et/ou d'esters de l'acide méthacrylique et/ou de leurs acides libres de formule

$$CH_2=C(R_1)(COOR_2) \qquad (I),$$

où $R_1$ = H ou $CH_3$ et $R_2$ représente une chaîne alkyle comprenant 1 à 20 atomes de carbone ou H, et
b) 15 à 50% en poids, par rapport au poids total, de composés de vinyle, d'esters de l'acide acrylique ou d'esters de l'acide méthacrylique, copolymérisables, présentant à chaque fois au moins un atome de phosphore, une polymérisation par voie radicalaire ou anionique.

**7.** Procédé pour la préparation de bandes autoadhésives à l'aide d'une masse autoadhésive selon la revendication 1, **caractérisé en ce que** les polymères pouvant être obtenus dans la revendication 6 sont revêtus à partir de la masse fondue, en particulier avec une proportion résiduelle de solvant inférieure à 1%.

**8.** Procédé selon la revendication 7, **caractérisé en ce qu'**une orientation est obtenue dans la masse autoadhésive résistante à la flamme grâce au revêtement à partir de la masse fondue.

**9.** Procédé pour la préparation de bandes autoadhésives selon l'une ou plusieurs des revendications 7 ou 8, **caractérisé en ce qu'**on utilise, comme matériau support, des feuilles siliconées ou fluorées, des papiers de séparation ou des feuilles contenant des agents ignifuges.

**10.** Procédé pour la préparation de bandes autoadhésives selon l'une ou plusieurs des revendications 6 à 9, **caractérisé en ce qu'**une réticulation de la masse autoadhésive est réalisée au moyen d'une irradiation hautement énergétique ou thermiquement.

**11.** Bande autoadhésive, pouvant être obtenue selon l'une ou plusieurs des revendications 7 à 10, **caractérisée en ce que** le matériau support est également résistant à la flamme selon la norme DIN 40633.

**12.** Utilisation de masses autoadhésives d'acrylate selon la revendication 1 pour des bandes autoadhésives résistantes à la flamme selon la norme DIN 40633 et thermoactivables.

**13.** Utilisation de bandes autoadhésives ou de masses autoadhésives selon l'une ou plusieurs des revendications 1 à 6 ou 11 pour la préparation ou le collage de circuits imprimés souples (Flexible Printed Circuit Boards).

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **FOUASSIER.** Photoinititation, Photopolymerization and Photocuring: Fundamentals and Applications. Hanser-Verlag, 1995
- Chemistry and Technology of UV and EB Formulation for Coatings. **CARROY et al.** Inks and Paints. SITA, 1994
- **DONATAS SATAS.** Handbook of Pressure Sensitive Adhesive Technology. van Nostrand, 1989
- **KANN CARROY et al.** Chemistry and Technology of UV and EB Formulation for Coatings, Inks and Paints. SITA, 1994
- **T.G. FOX.** *Bull. Am. Phys. Soc.,* 1956, vol. 1, 123
- **HOUBEN WEYL.** *Methoden der Organischen Chemie,* vol. E 19a, 60-147
- Electron Beam Processing, in Chemistry and Technology of UV and EB formulation for Coatings. **SKELHORNE.** Inks and Paints. SITA, 1991, vol. 1